# EUROPÄISCHE PATENTANMELDUNG

(11) **EP 4 075 469 A1**
(43) Veröffentlichungstag der Anmeldung: **19.10.2022**
(21) Anmeldenummer: 21168516.9
(22) Anmeldetag: 15.04.2021
(51) Int. Cl.: H01H 59/00, B81B 7/00, H01H 1/00

(54) **MIKROELEKTROMECHANISCHES SCHALTELEMENT, VORRICHTUNG UND BETRIEBSVERFAHREN**

(71) Anmelder: Siemens Aktiengesellschaft, 80333 München (DE)
(72) Erfinder: Raab, Oliver, 94496 Ortenburg (DE); Schwarz, Markus, 80798 München (DE); Wilke, Hans, 85599 Parsdorf (DE)

(57) **Zusammenfassung**

Es wird ein mikroelektromechanisches Schaltelement (1) angegeben, umfassend
- ein mehrschichtiges Trägersubstrat (50) mit einer funktionellen Schicht (53), in der ein auslenkbares Biegeelement (10) ausgebildet ist,
- sowie ein Sensorelement (20,20a-20h), welches zur Messung einer Temperatur ausgelegt ist und in der unmittelbaren Umgebung des Biegeelements (10) angeordnet ist und diesem zugeordnet ist.

Weiterhin wird eine Vorrichtung mit einem oder mehreren solchen Schaltelementen (1) und ein Verfahren zum Betrieb eines solchen Schaltelements oder einer solchen Vorrichtung angegeben.

## Beschreibung

Die vorliegende Erfindung betrifft ein mikroelektromechanisches Schaltelement mit einem mehrschichtigen Trägersubstrat, in der eine funktionelle Schicht mit einem auslenkbaren Biegeelement ausgebildet ist. Weiterhin betrifft die Erfindung eine Vorrichtung mit einem solchen Schaltelement sowie ein Verfahren zum Betrieb eines solchen Schaltelements bzw. einer solchen Vorrichtung.

Aus dem Stand der Technik sind mikroelektromechanische Schaltelemente grundsätzlich bekannt und werden in der Fachwelt auch als MEMS-Schaltelemente bezeichnet. Es handelt sich dabei um mechanische Festkörper-Schaltelemente, welche im Mikrometer- bis Nanometer-Bereich strukturiert sind und elektrostatisch aktuierte Biegeelemente umfassen, so dass sie durch die Änderung einer elektrischen Spannung geschaltet werden können. Häufig wird eine Mehrzahl solcher einzelner MEMS-Schalter zu einem Array angeordnet, insbesondere um eine hinreichend große Stromtragfähigkeit und/oder Spannungsfestigkeit zu erreichen. Solche MEMS-Schalter und darauf aufbauende Schaltvorrichtungen werden beispielsweise in der DE 10 2017 215 236 A1 und der WO 2018028947 A1 beschrieben. Gegenstand der DE 10 2017 215 236 A1 ist ein MEMS-Schalter, welcher auf einem Silicon-on-Insulator-Substrat (SOI-Substrat) aufgebaut ist. Mit dieser Fertigungstechnologie können aufgrund der ausgereiften und reproduzierbaren Herstellungsprozesse die vorgegebenen Schaltzeiten besonders präzise eingestellt werden. Dabei wird das Biegeelement mittels subtraktiver Fertigung aus einer funktionellen Siliziumschicht freigestellt. Die Trägerschicht des SOI-Substrates wird hier von der Rückseite des Substrats aus im Bereich des Biegebalkens entfernt, so dass eine Auslenkung des Biegebalkens in vertikaler Richtung ermöglicht wird. Auf der Vorderseite des SOI-Substrats (der Seite mit dem Biegeelement) wird typischerweise ein Decksubstrat angeordnet, welches ebenfalls im Bereich des Biegebalkens eine Ausnehmung aufweist. In diesem Bereich des Decksubstrats können eine Steuerelektrode sowie ein oder mehrere Gegenkontakte für den Schaltvorgang angeordnet sein.

Nachteilig bei den MEMS-Schaltern nach dem Stand der Technik ist, dass die einzelnen Schaltelemente sehr empfindlich sind, und dass es z.B. bei einem Kurzschlussstrom im Laststromkreis oder bei einer anderen außerplanmäßigen elektrischen, mechanischen und/oder thermischen Belastung leicht zu einer Beschädigung kommen kann. Dies gilt sowohl für einzeln verwendete Schaltelemente als auch für Schaltelemente, die Teil eines übergeordneten Arrays sind. Wenn eine solche Schädigung bzw. eine solche außerplanmäßige Belastung nicht erkannt wird, kann ausgehend davon auch eine Schädigung einer übergeordneten Vorrichtung die Folge sein. Ein besonders empfindlicher Bestandteil des Schaltelements ist hier das auslenkbare Biegeelement selbst.

Aufgabe der Erfindung ist es daher, ein Schaltelement zur Verfügung zu stellen, welches diesen Nachteil überwindet. Insbesondere soll ein Schaltelement mit einer höheren Ausfallsicherheit zur Verfügung gestellt werden. Eine weitere Aufgabe ist es, eine Vorrichtung mit einem solchen Schaltelement sowie ein Verfahren zum Betrieb eines solchen Schaltelements bzw. einer solchen Vorrichtung anzugeben.

Diese Aufgaben werden durch das in Anspruch 1 beschriebene Schaltelement, die in Anspruch 13 beschriebene Vorrichtung und das in Anspruch 14 beschriebene Betriebsverfahren gelöst.

Das erfindungsgemäße mikromechanische Schaltelement weist ein mehrschichtiges Trägersubstrat mit wenigstens einer funktionalen Schicht auf. In dieser funktionalen Schicht ist ein Biegeelement ausgebildet. Außerdem weist das Schaltelement ein Sensorelement auf, welches zur Messung einer Temperatur ausgelegt ist. Das Sensorelement ist in der unmittelbaren Umgebung des Biegeelements angeordnet und diesem zugeordnet.

Unter einem mikroelektromechanischen Schaltelement soll hier ein Schaltelement verstanden werden, welches mit den Mitteln der Mikrosystemtechnik hergestellt ist. Dabei wird unter dem Begriff Mikrosystemtechnik ganz allgemein die Technik verstanden, die in der Lage ist, mikroskopisch kleine mechanisch wirksame Komponenten herzustellen, die eine Bewegung vollziehen können, beispielsweise Schalter oder Zahnräder. Unter dem Begriff der Mikrosystemtechnik soll hier im weiteren Sinne auch die Nanosystemtechnik eingeschlossen sein, welche entsprechende Strukturen im Submikrometer- bis Nanometerbereich ermöglicht. Allgemein wird hier in der Regel auf Technologien zurückgegriffen, die aus der Halbleiterfertigung grundsätzlich bekannt sind. Solche MEMS-Schalter können auf Glas-, Saphir- und/oder Halbleiter-Substraten (sogenannten Wafern), beispielsweise aus Silizium oder Galliumarsenid gefertigt werden. Die Länge eines MEMS-Schaltelements beträgt hierbei weniger als 1mm, bevorzugt weniger als 500 µm. Hierbei ist das größte konstruktive Element eines einzelnen MEMS-Schaltelements typischerweise das Biegeelement. Dieses Biegeelement ist zweckmäßigerweise länglich geformt, um eine definierte, rückfedernde Auslenkung nach Art einer geraden Blattfeder zu ermöglichen. Das Biegeelement wird daher in den Fachkreisen häufig auch als Biegebalken oder als Schaltzunge bezeichnet. Grundsätzlich sind aber auch andere Formen und Proportionen möglich. Das Biegeelement kann insbesondere durch einen freigestellten Teilbereich der erwähnten funktionalen Schicht gebildet sein. Zusätzlich zu dieser kann das mehrschichtige Trägersubstrat auch ggf. noch weitere funktionale Schichten aufweisen. Durch eine Auslenkung des Biegeelements kann ein übergeordneter Schaltkreis geöffnet bzw. geschlossen werden.

Das Sensorelement dient zur Messung einer Temperatur in der unmittelbaren Umgebung des Biegeelements. Es ist diesem zugeordnet in dem Sinne, dass mit dem Sensorelement eine Temperaturänderung dieses einen Biegeelements gemessen werden kann.

Hierzu ist das Sensorelement so nah an dem Biegeelement angeordnet, dass eine beim Schaltvorgang verursachte Temperaturänderung im Endbereich des Biegeelements (der sogenannten Balkenspitze, die typischerweise einen Schaltkontakt trägt) gemessen werden kann. Diese Temperaturänderung kann insbesondere ein Temperaturanstieg beim Schließen eines Laststromkreises sein, aber auch beispielsweise ein Temperaturabfall beim Öffnen des Laststromkreises. Auch im geschlossenen Zustand des Schalters ist auf diese Weise eine Detektion von Spannungsspitzen und/oder Fehlerströmen in Folge der damit verbundenen Erwärmung möglich.

Ein wesentlicher Vorteil des erfindungsgemäßen Schaltelements ist, dass durch die Möglichkeit der Temperaturmessung in der unmittelbaren Umgebung des Biegeelements eine Überwachung der Funktion des Schaltelements ermöglicht wird. So kann beispielsweise durch die Messung des mit dem Schaltvorgang verbundenen Temperaturanstiegs bzw. Temperaturabfalls auf das tatsächliche Öffnen und Schließen des Laststromkreises geschlossen werden. Wenn im Endbereich des Biegeelements ein Schaltkontakt angeordnet ist, der beim geschlossenen Last-stromkreis in diesen einbezogen ist, wird gerade hier beim Stromfluss im Laststromkreis Wärme freigesetzt. Wenn beim Schließen des Schalters eine Erhöhung der Temperatur innerhalb eines vordefinierten Sollbereichs gemessen wird, kann daraus auf einen ordnungsgemäßen Betrieb geschlossen werden. Wenn die Temperatur den Sollbereich überschreitet, kann dies ein Hinweis darauf sein, dass der Schalter zwar geschlossen hat, dass aber eine Schädigung im Bereich des Schaltelements und/oder ein unerwünscht hoher Belastungszustand (z.B. ein Kurzschluss) im Laststromkreis vorliegt. So kann das Überschreiben des Sollbereichs ein Hinweis auf einen Fehlerfall sein. Die Erkennung eines solchen Fehlerfalls kann besonders vorteilhaft dazu benutzt werden, das betroffene Schaltelement gezielt zu deaktivieren, um den fehlerhaften Zustand zu beenden und insbesondere eine weitere Schädigung von diesem und/oder anderen Bauteilen zu vermeiden.

Die erfindungsgemäße Vorrichtung weist ein erfindungsgemäßes Schaltelement bzw. ein Array von mehreren solchen erfindungsgemäßen Schaltelementen auf. Unabhängig von dem speziellen Anwendungszweck der Vorrichtung ergeben sich ihre Vorteile analog zu den oben beschriebenen Vorteilen des erfindungsgemäßen Schaltelements, insbesondere im Hinblick auf die Detektion eines Fehlerzustands und die mögliche Deaktivierung des betroffenen Schaltelements. Bei einer Vorrichtung mit einem Array aus mehreren Schaltelementen ist es besonders vorteilhaft, wenn jedem Schaltelement ein separates Sensorelement zur Messung der lokalen Temperatur eindeutig zugeordnet ist. Dies ist jedoch nicht zwingend erforderlich. Wesentlich ist, dass zumindest ein Schaltelement vorliegt, dem ein Sensorelement zur Messung der Temperatur in seiner unmittelbaren Umgebung zugeordnet ist. Gegebenenfalls kann schon aus nur einem solchen lokalen Temperatursignal auf einen Fehlerfall im Laststromkreis geschlossen werden.

Das erfindungsgemäße Verfahren ist ein Betriebsverfahren für ein erfindungsgemäßes Schaltelement oder eine erfindungsgemäße Vorrichtung mit einem oder mehreren solchen Schaltelementen. Es umfasst die folgenden Schritte:
a) Umschalten zwischen einem ON-Zustand und einem OFF-Zustand eines übergeordneten Laststromkreises durch eine Auslenkung des Biegeelements,
b) Messen einer Temperatur in der unmittelbaren Umgebung des Biegeelements mit dem Sensorelement.
Die mit der lokalen Temperaturmessung verbundenen Vorteile ergeben sich analog zu den oben beschriebenen Vorteilen des erfindungsgemäßen Schaltelements.

Vorteilhafte Ausgestaltungen und Weiterbildungen der Erfindung gehen aus den von den Ansprüchen 1 und 14 abhängigen Ansprüchen sowie der folgenden Beschreibung hervor. Dabei können die beschriebenen Ausgestaltungen des Schaltelements, der Vorrichtung und des Betriebsverfahrens allgemein vorteilhaft miteinander kombiniert werden.

So kann der Abstand zwischen Sensorelement und Biegeelement in lateraler Richtung so gewählt sein, dass er höchstens so groß ist wie die Ausdehnung des Biegeelements in dieser Richtung. Unter der lateralen Richtung soll dabei allgemein eine Richtung parallel zur Schichtebene des mehrschichtigen Trägersubstrats verstanden werden. Wenn die laterale Position des Sensorelement derart auf die unmittelbare Umgebung des Biegeelements beschränkt ist, dann kann damit eine durch den Schaltvorgang verursachte Temperaturänderung im Bereich des Biegeelements selbst (insbesondere in dessen Endbereich) besonders empfindlich nachgewiesen werden. Der Absolutwert für den lateralen Abstand kann dabei insbesondere unterhalb von 600 µm liegen. Auch in vertikaler Richtung ist der Abstand zwischen Sensorelement und Biegeelement vorteilhaft sehr klein, insbesondere weniger als die Dicke des mehrschichtigen Trägersubstrats. Unter der vertikalen Richtung soll hier entsprechend die Raumrichtung senkrecht zur Schichtebene verstanden werden. Allgemein kann die Auslenkrichtung des Biegeelements im Wesentlichen senkrecht zur Schichtebene orientiert sein.

Gemäß einer weiteren allgemein vorteilhaften Ausführungsform kann das Decksubstrat eine Steuerelektrode aufweisen, mit welcher die Auslenkung des Biegeelements beeinflusst werden kann. Diese Steuerelektrode ist zweckmäßig gegenüber dem Biegeelement platziert, und auf ihr kann im Betrieb die Schaltspannung aufgebracht werden. Eine solche Steuerelektrode wird im Stand der Technik zum Teil auch als Gate-Elektrode bezeichnet. Durch elektrostatische Wechselwirkung zwischen der Steuerelektrode und dem Biegeelement kann das Biegeelement ausgelenkt werden. Z.B. kann es aufgrund von elektrostatischer Anziehung in Richtung des Decksubstrats bewegt werden, so dass es bei dieser Auslenkung zur Ausbildung eines elektrischen Kontakts zwischen einem Kontaktelement des Biegebalkens und einem Kontaktelement des Decksubstrats kommt. Allgemein kann mittels der Steuerelektrode zwischen einem offenen und einem geschlossenen Zustand des Schaltelements umgeschaltet werden. Diese Steuerelektrode kann insbesondere Teil eines Steuerstromkreises sein.

Allgemein kann das Schaltelement dazu ausgelegt sein, einen Laststromkreis zu öffnen und zu schließen. Außerdem kann das Sensorelement Teil eines Messstromkreises sein. Besonders vorteilhaft ist es in diesem Fall, wenn der Messtromkreis von dem Laststromkreis und/oder dem Steuerstromkreis galvanisch getrennt ist. Diese galvanische Trennung soll insbesondere sowohl im offenen als auch im geschlossenen Zustand des Schaltelements bestehen. Unter der galvanischen Trennung soll dabei verstanden werden, dass die jeweiligen Stromkreise weder durch einen elektrischen Leiter noch durch einen Halbleiter miteinander verbunden sind, sondern dass sie durch wenigstens ein elektrisch isolierendes Element (beispielsweise eine Isolationsschicht) voneinander getrennt sind. Der wesentliche Vorteil der galvanischen Trennung des Messstromkreises von zumindest einem der beiden anderen Stromkreise liegt darin, dass durch den integrierten Temperatursensor keine elektrische Verbindung zwischen Steuerstromkreis und Laststromkreis geschaffen wird. Allgemein ist es nämlich besonders bevorzugt, wenn in dem Schaltelement der Steuerstromkreis und der Laststromkreis galvanisch getrennt sind. Damit können gegenseitige Störungen zwischen dem Steuerstromkreis und dem Laststromkreis vorteilhaft vermieden werden. Diese Trennung wird vorteilhaft von der erfindungsgemäßen Integration eines Temperatursensors nicht beeinträchtigt. Prinzipiell kann der Messstromkreis mit einem der anderen beiden Stromkreise elektrisch verbunden sein, ohne dass es zu der unerwünschten Kopplung zwischen Steuer- und Laststromkreis käme. Besonders vorteilhaft ist es aber, wenn sogar alle drei Stromkreise voneinander galvanisch getrennt sind.

Allgemein vorteilhaft kann das Schaltelement ein Decksubstrat aufweisen. Dabei kann an dem Biegeelement ein Schaltkontakt angeordnet sein und das Decksubstrat kann wenigstens einen Gegenkontakt tragen, welcher abhängig von einer Auslenkung des Biegeelements mit dem Schaltkontakt des Biegeelements kontaktierbar ist. Es kann dann also, wenn das Biegeelement zum Decksubstrat hin ausgelenkt ist und in seinem Endbereich mit diesem in Berührung ist, ein elektrischer Kontakt zwischen dem Schaltkontakt des Biegeelements und einem auf dem Decksubstrat gegenüberliegend angeordneten Gegenkontakt vermittelt werden. Besonders bevorzugt trägt das Decksubstrat sogar ein Paar von Gegenkontakten, welche beide mit dem Schaltkontakt des Biegeelements kontaktiert werden können. Auf diese Weise wird also in der zum Decksubstrat hin ausgelenkten Stellung das Paar von Gegenkontakten elektrisch miteinander verbunden. Diese beiden Gegenkontakte können als sogenannte Lastkontakte des Lastschaltkreises ausgebildet sein. So kann mittels des Schaltkontakts der Lastschaltkreis geschlossen werden, und das Schaltelement ist hier in einer "ON"-Position. Wenn Schaltkontakt und Gegenkontakt(e) nicht verbunden sind, ist das Schaltelement in einer "OFF"-Position. In der ON-Position sind dann sowohl der Schaltkontakt als auch der bzw. die Gegenkontakt(e) Teil des Laststromkreises, der vorteilhaft von dem Steuerstromkreis und gegebenenfalls auch von dem Messstromkreis galvanisch getrennt ist.

Durch das Decksubstrat kann vorteilhaft ein Hohlraum gebildet sein, in dem das Biegeelement auslenkbar angeordnet ist. Hierzu kann das Decksubstrat eine Ausnehmung und/oder eine umlaufende Abstandsschicht aufweisen, durch welche zumindest ein Teil dieses Hohlraums definiert ist. Das Decksubstrat kann funktional als elektrisch isolierendes Decksubstrat ausgebildet sein und insbesondere im Wesentlichen aus Glas oder Silizium gebildet sein. Dies soll so verstanden werden, dass das Glas oder Silizium den Hauptbestandteil des Decksubstrats bildet und zusätzliche Elemente, insbesondere in Form von lokalen Beschichtungen, dabei nicht ausgeschlossen sein sollen. So können insbesondere eine Steuerelektrode sowie zusätzliche Kontaktelemente und ggf. das Sensorelement als weitere Elemente auf der Oberfläche des Decksubstrats aufgebracht sein. Insbesondere können Steuerelektrode und/oder Kontaktelement(e) auf der dem Biegeelement zugewandten Seite des Decksubstrats angeordnet sein. Es können jedoch auch auf der Außenseite des Decksubstrats z.B. Metallisierungen in Form von Leitungselementen und/oder Kontaktelementen und/oder anderen Bauelementen vorhanden sein. Zwischen den beiden Hauptflächen des Decksubstrats können elektrische Durchführungen vorgesehen sein, insbesondere in Form von sogenannten Vias, welche sich senkrecht zur Substratoberfläche durch das Substrat hindurch erstrecken, um Elemente auf Ober- und Unterseite elektrisch zu verbinden. Alternativ kann jedoch auch ein Decksubstrat aus einem leitfähigen Material zum Einsatz kommen, das auf der dem Biegeelement zugewandten Seite mit einer elektrisch isolierenden Schicht beschichtet ist, so dass rein funktional ein elektrisch isolierendes Decksubstrat gebildet ist. Eine solche elektrisch isolierende Schicht kann beispielsweise eine Siliziumdioxid-Schicht oder auch eine Polymerschicht sein.

Gemäß einer vorteilhaften Ausführungsform kann das mehrschichtige Trägersubstrat ein Silicon-on-Insulator-Schichtsystem sein oder ein solches Schichtsystem umfassen. Ein Silicon-on-Insulator (abgekürzt: SOI) Schichtsystem umfasst insbesondere eine Silizium-Isolator-Silizium-Schichtfolge, wobei die untere Siliziumschicht eine Trägerschicht ausbildet und die obere Siliziumschicht die funktionelle Schicht darstellt, aus der das Biegeelement gebildet ist. Vorteilhaft kann es sich bei einer der beiden Silizium-Schichten und besonders bevorzugt bei beiden Silizium-Schichten um monokristallines Silizium handeln. Die Isolator-Schicht kann bevorzugt im Wesentlichen durch eine Siliziumdioxid-Schicht (SiO₂) gebildet sein. Sie kann insbesondere als sogenannte vergrabene Oxidschicht (englisch: "buried oxide" oder kurz BOX-Schicht) realisiert sein. Die an sich bekannte SOI-Technologie ermöglicht eine besonders präzise Definition der Schichtdicken und der sonstigen Materialeigenschaften der einzelnen Schichten. Die Halbleiterschicht, aus der das Biegeelement freigestellt wird, ist insbesondere die dünnere der beiden Silizium-Schichten eines solchen SOI-Substrats. Die mechanische Anbindung des Biegeelements an die übrigen Bereiche des Bauteils kann insbesondere über die Isolator-Schicht des SOI-Substrats vermittelt sein. Mit anderen Worten kann das Biegeelement in seinem Fußbereich über die Isolator-schicht an einen mechanisch tragenden Teil des Schaltelements angekoppelt sein. Diese und weitere vorteilhafte Merkmale und Ausführungsvarianten des SOI-Schichtsystems und seiner Prozessierung werden ausführlicher in der DE 10 2017 215 236 A1 beschrieben, welche daher in ihrer Gesamtheit in die Offenbarung der vorliegenden Anmeldung mit einbezogen sein soll. Alternativ zu der oben beschriebenen SOI-Schichtfolge kann die Trägerschicht aber auch beispielsweise durch eine Saphirschicht gebildet sein.

Gemäß einer ersten Ausführungsvariante für die Position des Sensorelements kann dieses zumindest teilweise in die funktionelle Schicht des Biegeelements integriert sein und/oder auf das Biegeelement aufgebracht sein. Bei dieser Ausführungsform kann das Biegeelement insbesondere ein halbleitendes Material aufweisen oder sogar im Wesentlichen aus einem solchen halbleitenden Material gebildet sein, und dieses Halbleitermaterial kann gleichzeitig als funktionelle Schicht des Sensorelements dienen. So kann beispielsweise ein p-n-Übergang in das Halbleitermaterial eingebracht sein, dessen temperaturabhängiges Verhalten für das Sensorelement genutzt wird. Alternativ kann ein temperaturabhängiger Widerstand im Halbleitermaterial selbst gemessen werden, beispielsweise kann ein sogenannter Ausbreitungswiderstand gemessen werden (englisch: "spreading resistance"). Je nach Temperaturbereich und Dotiergrad kann das Halbleitermaterial dabei einen positiven Temperaturkoeffizienten aufweisen (also ein Kaltleiter sein) oder auch einen negativen Temperaturkoeffizienten aufweisen (also ein Heißleiter sein).

Alternativ kann auf das Grund-Material des Biegeelements aber auch eine funktionelle Schicht aufgebracht sein, in der die Temperaturmessung stattfindet. So kann zum Beispiel eine insbesondere mäanderförmige Widerstandsstruktur (aus einem Kaltleiter oder Heißleiter) als zusätzliche Schicht auf dem Biegeelement aufgebracht sein. Auch bei dieser Variante kann das Grund-Material des Biegeelements ein Halbleitermaterial sein, wobei dann vorteilhaft zwischen dem Halbleitermaterial und der Widerstandsstruktur eine isolierende Schicht angeordnet ist. Hierdurch wird auch eine galvanische Trennung zwischen dem Messstromkreis und dem Steuerstromkreis (in den das Biegeelement eingebunden ist) erreicht. Grundsätzlich kann das Biegeelement aber auch aus einem oder mehreren Dielektrika gebildet sein, auf dem ein oder mehrere funktionelle Schichten für das Sensorelement aufgebracht sind. Auch die Gegenelektrode für die Steuerelektrode müsste dann durch eine leitfähige Schicht auf dem nichtleitenden Biegeelement definiert sein. Allgemein und unabhängig vom Material des Biegeelements und vom Aufbau des Sensorelements können zusätzliche weitere funktionale Schichten vorgesehen sein, beispielsweise zusätzliche Metallisierungen, um Zuleitungen und/oder Elektroden für das Sensorelement zu definieren.

Allgemein vorteilhaft ist bei allen Varianten, bei denen das Sensorelement im oder am Biegeelement angeordnet ist, der Messstromkreis vom Laststromkreis galvanisch getrennt. Wenn das Sensorelement das Material eines halbleitenden Biegeelements nutzt, wird der Messstromkreis typischerweise mit dem Steuerstromkreis verbunden sein. Wenn eine separate funktionelle Schicht genutzt wird, kann auch bei der Anordnung auf dem Biegeelement eine galvanische Trennung zwischen Messstromkreis und Steuerstromkreis erreicht werden.

Gemäß einer zweiten Ausführungsvariante für die Position des Sensorelements kann dieses in eine tieferliegende Schicht des mehrschichtigen Trägersubstrats integriert sein. Beispielsweise kann eine aus Silizium gebildete Trägerschicht eines Silicon-on-Insulator-Schichtsystems für die Messung eines Ausbreitungswiderstands genutzt werden. Ein solches Sensorelement kann insbesondere im Fußbereich des Biegeelements ausgebildet sein.

Gemäß einer dritten Ausführungsvariante für die Position des Sensorelements kann das Schaltelement ein Decksubstrat aufweisen und das Sensorelement kann zumindest teilweise in das Decksubstrat integriert sein und/oder auf dem Decksubstrat aufgebracht sein. Auch hierbei kann vorteilhaft eine Widerstandsstruktur oder eine andere funktionelle Schicht auf das Decksubstrat aufgebracht sein, um dort eine lokale Temperaturänderung zu messen. Dieses Sensorelement kann insbesondere in der unmittelbaren Umgebung von auf dem Decksubstrat angeordneten Gegenkontakten angeordnet sein, wobei diese Gegenkontakte Teil des Laststromkreises sind. Trotz dieser räumlichen Nähe zu den Gegenkontakten kann auch hier eine galvanische Trennung des Messstromkreises vom Laststromkreis erreicht werden, insbesondere wenn das Sensorelement lateral neben den Gegenkontakten angeordnet ist bzw. wenn zwischen der funktionellen Schicht des Sensorelements und einem jeweils überlappenden Gegenkontakt eine Isolationsschicht angeordnet ist. Auch eine galvanische Trennung vom Steuerstromkreis kann bei dieser dritten Ausführungsvariante problemlos erreicht werden, insbesondere wenn das Sensorelement von der Steuerelektrode lateral beabstandet ist.

Im Folgenden werden verschiedene vorteilhafte Ausführungsvarianten für den Aufbau bzw. das Funktionsprinzip des Sensorelements angegeben. Diese verschiedenen Varianten können jeweils an den oben genannten vorteilhaften Positionen zum Einsatz kommen. Gemäß einer ersten Ausführungsvariante für den Aufbau des Sensorelements kann dieses allgemein vorteilhaft einen in Dünnschichttechnologie aufgebrachten Kaltleiter aufweisen. Dabei kann es sich um eine insbesondere mäanderförmige Widerstandsstruktur aus einem Material mit einem positiven Temperaturkoeffizienten handeln, also beispielsweise einem Metall oder aber auch einem entsprechenden Halbleiter. Eine solche Struktur kann mit den üblichen Fertigungstechnologien für MEMS-Bauteile sehr leicht an unterschiedlichen Orten erzeugt werden.

Gemäß einer zweiten Ausführungsvariante kann das Sensorelement einen p-n-Übergang innerhalb einer Halbleiterschicht aufweisen und/oder auf der Messung einer Widerstandsänderung in einer Halbleiterschicht basieren. Durch den p-n-Übergang kann beispielsweise eine Diode oder ein Transistor definiert sein, dessen temperaturabhängige Eigenschaften mit dem Messstromkreis gemessen werden. Dieser p-n-Übergang kann insbesondere durch Einbringung von entsprechenden Dotierprofilen in eine Haltleiterschicht (insbesondere eine Siliziumschicht) des Biegeelements erzeugt werden. Es kann aber auch ein p-n-Übergang an einer anderen lateralen Position dieser funktionellen Halbleiterschicht erzeugt werden, insbesondere auch im Bereich der Aufhängung des Biegeelements oder am gegenüberliegenden Ende, also in dem um das Biegeelement umlaufenden Bereich, gegenüber der Balkenspitze. Alternativ zur Verwendung eines p-n-Übergangs kann aber auch ein Ausbreitungswiederstand im Halbleitermaterial gemessen werden, oder es kann eine (insbesondere mäanderförmige) Widerstandsstruktur in einer solchen Halbleiterschicht definiert sein, wobei der Halbleiter wiederum entweder als Kaltleiter oder als Heißleiter wirken kann.

Gemäß einer dritten Ausführungsvariante für den Aufbau des Sensorelements kann dieses als Thermoelement ausgebildet sein. Mit anderen Worten kann dabei der thermoelektrische Effekt genutzt werden, der durch Kontaktpunkte unterschiedlicher Materialschichten zustande kommt. Hierzu können (ähnlich wie auch bei den anderen Ausgestaltungen des Sensorelements) entweder die ohnehin für die Funktion des Schaltelements benötigten Schichten genutzt werden, oder es können im Bereich des Sensorelements ein oder mehrere zusätzliche Materialschichten zur Ausbildung des Thermoelements aufgebracht werden.

Bei allen bisher beschriebenen Ausführungsvarianten für den Aufbau des Sensorelements ist dieses in das Schichtsystem des Schaltelements integriert und insbesondere zusammen mit dem Schaltelement gefertigt. Diese gemeinsame Fertigung und enge Integration ist auch im Hinblick auf eine möglichst einfache Herstellung als besonders vorteilhaft anzusehen. Gemäß einer vierten Ausführungsvariante für den Aufbau des Sensorelements kann dieses aber alternativ auch als vorgefertigtes Sensor-Bauteil gebildet sein, welches in das Schaltelement eingebaut ist. Dieser nachträgliche Einbau ist fertigungstechnisch etwas aufwändiger, allerdings kann der Einfluss des zusätzlichen Sensorelements auf die Schichtabfolge und den Herstellungsprozess des übrigen Schaltelements dann sehr gering gehalten werden. Ein solches vorgefertigtes Sensor-Bauteil kann wiederum auf bekannten Methoden der Temperaturmessung beruhen, insbesondere auch auf den bereits oben genannten. Bei einem Array von mehreren Schaltelementen kann ein solches vorgefertigtes Sensor-Bauteil entweder im Bereich von nur einem Schaltelement eingebaut sein, oder es können mehrere solche Sensor-Bauteile vorliegen, die jeweils einem eigenen Schaltelement zugeordnet sind und in dessen unmittelbarer Umgebung angeordnet sind.

Allgemein und unabhängig von der genauen Ausgestaltung des einzelnen Schaltelements kann die übergeordnete Vorrichtung ein Array von mehreren Schaltelementen aufweisen. Diese können alle auf die erfindungsgemäße Weise ausgelegt sein, wesentlich ist aber nur, dass zumindest ein Schaltelement in dem Array auf die erfindungsgemäße Weise mit einem dicht integrierten Temperatursensor ausgestattet ist. Ein solches Array kann eine Parallelschaltung und/oder eine Serienschaltung von mehreren Schaltelementen sein. Eine Parallelschaltung mehrerer Schaltelemente kann insbesondere dazu dienen, die Stromtragfähigkeit der gesamten Vorrichtung im Vergleich zu einem einzelnen Schaltelement zu erhöhen. Eine Serienschaltung mehrerer Schaltelemente kann insbesondere dazu dienen, die Spannungsfestigkeit im Vergleich zu einem einzelnen Schaltelement zu erhöhen. Auf diese Weise kann die Verwendung eines Arrays dazu beitragen, dass die Vorrichtung die Spezifikationen eines Leistungsschalters einer elektrischen Energieverteilerleitung - insbesondere in einem Niederspannungs- oder Mittelspannungsnetz - erfüllt. Die Anzahl der einzelnen Schaltelemente in dem Array kann dabei an den jeweiligen Spezifikationen ausgerichtet werden. Sie kann beispielsweise bei einigen 10 bis einigen 1000 Schaltelementen liegen und für höhere Leistungsbereiche sogar mehrere hunderttausend betragen. Bei Vorliegen eines solchen Arrays kann besonders bevorzugt jedem einzelnen Biegeelement ein eigenes Sensorelement zugeordnet sein, welches in der unmittelbaren Umgebung des jeweiligen Biegeelements angeordnet ist. So kann die Funktionsweise und der Betriebszustand jedes einzelnen Schaltelements in dem Array lokal überwacht werden.

Gemäß einer weiteren vorteilhaften Ausführungsform der Vorrichtung kann diese neben dem wenigstens einen Schaltelement ein oder mehrere dazu elektrisch in Serie oder parallel geschaltete Halbleiterelemente umfassen. Dabei kann es sich beispielsweise um Transistoren oder andere Halbleiterschaltelemente handeln, wie in der WO 2018028947 A1 beschrieben. Die zusätzlichen Halbleiterelemente können dabei grundsätzlich auf demselben Substrat wie das Biegeelement gefertigt sein, also monolithisch integriert sein, oder sie können prinzipiell auch auf einem anderen Substrat gefertigt und erst nachträglich mit dem Schaltelement verbunden sein.

Die übergeordnete Vorrichtung kann für den Einsatz in ganz unterschiedlichen Anwendungen ausgelegt sein. So kann sie beispielsweise als Schaltgerät bzw. Schaltschütz, als Umrichter bzw. als Inverter, als Logikschaltung und/oder als logisches Gatter ausgebildet sein. Bei dem Schaltgerät oder Schaltschütz kann es sich insbesondere um ein Gerät für ein Niederspannungs- oder Mittelspannungsnetz handeln. Die Vorrichtung kann allgemein auch eine speicherprogrammierbare Steuerung, insbesondere eine Steuerung für eine industrielle Anlage sein. Erfindungsgemäße Schaltelemente können dabei beispielsweise in einer Eingangsstufe, einer Ausgangsstufe und/oder in einem Sicherheitsrelais einer solchen Anlagensteuerung zum Einsatz kommen.

Bei einer vorteilhaften Weiterbildung des Betriebsverfahrens kann dieses die folgenden zusätzlichen Schritte umfassen:
c) Vergleichen des Messsignals des Sensorelements mit einem vorgegebenen Schwellwert und
d) Deaktivierung des Schaltelements bei Über- oder Unterschreiten des Schwellwerts
sowie optional den weiteren Schritt
e) Überwachung eines Zustands des Schaltelements und/oder der Vorrichtung durch Vergleich von gemessenen Temperaturkurven.

Ähnlich wie die bereits beschriebenen Schritte a) und b) können auch diese weiteren Schritte wiederholt erfolgen. Insbesondere können die Schritte b), c) und d) und ggf. e) während des Betriebs immer wieder ausgeführt werden, so dass damit eine kontinuierliche Überwachung der korrekten Funktionsweise und bei Auftreten eines Fehlerzustands eine Deaktivierung des betroffenen Schaltelements ermöglicht ist. Wenn das Verfahren auf eine Vorrichtung mit einem Array aus mehreren Schaltelementen angewendet wird und insbesondere jedes Schaltelement ein eigenes Sensorelement aufweist, dann können entweder die Messignale der Sensorelemente alle einzeln ausgewertet und mit einem Schwellwert verglichen werden, oder es kann prinzipiell auch ein Summensignal von mehreren Sensorelementen mit einem solchen Schwellwert verglichen werden. Sowohl eine Einzel-Auswertung als auch eine Summen-Auswertung ermöglichen die Detektion eines Fehlerfalls, wenn das Signal aus dem vorgegebenen Sollbereich herausfällt.

Beim Schritt d) wird insbesondere bei Feststellung eines Fehlerfalls das Schaltelement deaktiviert. Damit kann zum einen das Schaltelement selbst vor einer weiteren Überlastung und Schädigung geschützt werden, zum anderen kann aber auch durch die Deaktivierung (also die dauerhafte Offen-Stellung des Schaltelements) ein übergeordneter Laststromkreis geschützt werden. Wenn das Betriebsverfahren auf eine Vorrichtung mit einem Array aus mehreren Schaltelementen angewendet wird, dann kann in Schritt b) entweder nur ein einzelnes, von dem Fehler betroffenes Schaltelement oder auch mehrere betroffene Schaltelemente oder auch das ganze Array abgeschaltet werden. Gemäß einer entsprechenden Ausführungsform des Schaltelements kann dieses eine Ansteuervorrichtung aufweisen, mit dem das Schaltelement bei Überschreiten eines vorgegebenen Schwellwerts des Messsignals deaktiviert werden kann. Gemäß einer entsprechenden Ausführungsform der Vorrichtung kann diese eine Ansteuervorrichtung aufweisen, welche zur selektiven Abschaltung von einzelnen Schaltelementen und/oder zur gemeinsamen Abschaltung eines Arrays aus mehreren Schaltelementen ausgelegt ist.

Auch Schritt e) kann zu einer nachfolgenden Deaktivierung des Schaltelements ähnlich wie bei Schritt d) führen, vor allem dann, wenn eine aktuell gemessene Temperaturkurve von einer vorgegebenen Sollkurve bzw. in früheren Betriebszuständen gemessenen Temperaturkurven zu stark abweicht.

Nachfolgend wird die Erfindung anhand einiger bevorzugter Ausführungsbeispiele unter Bezugnahme auf die angehängten Zeichnungen beschrieben, in denen:
- Figur 1: eine schematische Querschnittsdarstellung eines Schaltelements nach dem Stand der Technik zeigt,
- Figur 2: eine perspektivische Ausschnittsdarstellung eines weiteren bekannten Schaltelements zeigt,
- Figuren 3 bis 5: Querschnittsdarstellungen von Schaltelementen nach verschiedenen Beispielen der Erfindung zeigen,
- Figuren 6 bis 9: verschiedene Beispiele für die Ausgestaltung von Sensorelementen im oder am Biegeelement in schematischer Aufsicht zeigen,
- Figur 10: ein weiteres Beispiel im Querschnitt zeigt,
- Figuren 11 bis 13: verschiedene Beispiele für die Ausgestaltung von Sensorelementen im oder am Decksubstrat in schematischer Aufsicht zeigen,
- Figur 14: eine schematische Querschnittsdarstellung des Beispiels der Figur 13 zeigt und
- Figur 15: eine schematische Aufsicht für ein weiteres Beispiel mit einem Sensorelement am Decksubstrat zeigt.

In den Figuren sind gleiche oder funktionsgleiche Elemente mit gleichen Bezugszeichen versehen.

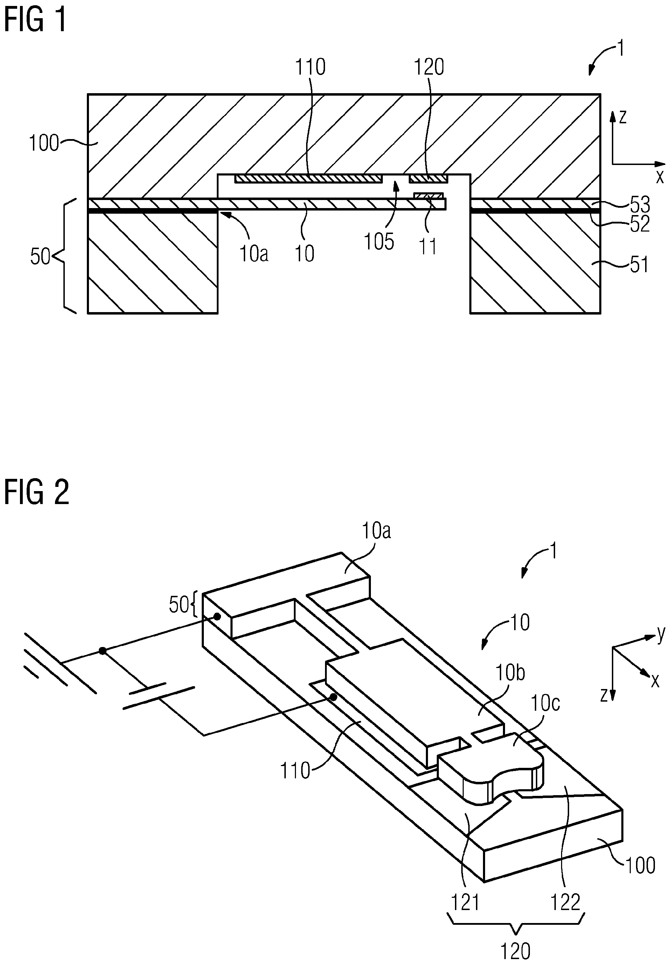

Figur 1 zeigt ein mikroelektromechanisches Schaltelement 1, welches aus dem Stand der Technik bekannt ist. Dieses Schaltelement ist insgesamt ähnlich aufgebaut wie in der DE 10 2017 215 236 A1 beschrieben, es ist hier jedoch der Übersicht halber etwas vereinfacht dargestellt. Das Schaltelement weist ein Silicon-on-Insulator-Schichtsystem 50 auf, welches eine erste Siliziumschicht 51, darauffolgend eine erste Oxidschicht 52 und darauffolgend eine zweite Siliziumschicht 53 umfasst. Auf die Schicht 53 kann auch zusätzlich noch eine zweite Oxidschicht als Teil des SOI-Schichtsystems 50 folgen oder zumindest während der Herstellung hier vorgelegen haben. Durch subtraktive Fertigung ist aus diesem SOI-Schichtsystem 50 und insbesondere aus deren zweiter Siliziumschicht 53 ein Biegeelement 10 definiert und freigestellt worden. Die Herstellung des Biegeelements umfasst dabei die Entfernung der umgebenden Bereiche der Siliziumschicht 53 und die lokale Entfernung der an das Biegeelement 10 angrenzenden Teile der Schichten 51 und 52. So wurde hier ein in der vertikalen Richtung auslenkbares Biegeelement 10 erzeugt, ähnlich wie in der DE102017215236A1 beschrieben. Auch die übrigen Fertigungsschritte können analog zu der DE 10 2017 215 236 A1 durchgeführt werden. Der Fußbereich 10a des Biegeelements, in dem dieses mechanisch mit den übrigen Teilen des SOI-Schichtsystems verbunden ist, ist hier etwas vereinfacht gestaltet bzw. gezeigt. Alternativ zu dieser einfacheren Realisierung kann der Fußbereich 10a aber auch analog zur DE 10 2017 215 236 A1 oder auch der noch nicht veröffentlichten europäischen Patentanmeldung 20182568.4 ausgestaltet sein.

Nach oben hin ist das Bauteil durch ein Decksubstrat 100 abgedeckt, welches beispielsweise aus Glas gebildet sein kann. Dieses Decksubstrat 100 kann beispielsweise durch einen Waferbond-Schritt mit den verbleibenden Schichten des SOI-Schichtsystems 50 verbunden worden sein. Im Bereich des Biegebalkens weist das Decksubstrat eine Ausnehmung 105 auf, so dass zusammen mit den Ausnehmungen der Schichten 51 und 52 ein Hohlraum gebildet wird, in dem das Biegeelement 10 ausgelenkt werden kann. Um diese Auslenkung zu bewirken, ist auf dem Decksubstrat 100 im Bereich oberhalb des Biegeelements 10 eine Steuerelektrode 110 vorgesehen. Durch eine Spannungsbeaufschlagung der Steuerelektrode 110 kann eine Auslenkung des Biegeelements elektrostatisch aktuiert werden. Wenn das Biegeelement 10 in Richtung z nach oben ausgelenkt wird, kann es in seinem Endbereich so weit in Kontakt mit dem Decksubstrat gebracht werden, dass ein auf dem Biegeelement 10 aufgebrachter Schaltkontakt 11 und ein in der Ausnehmung des Decksubstrats 100 aufgebrachter Gegenkontakt 120 elektrisch in Verbindung treten. Auf diese Weise kann das Schaltelement auf "ON" geschaltet werden, und ein zugehöriger Last-Stromkreis kann mit dem Schaltelement 1 geschlossen werden.

Das gezeigte Schaltelement 1 kann ein Teil einer übergeordneten Vorrichtung sein, welche insbesondere ein Array von untereinander ähnlichen Schaltelementen aufweisen kann. Ein solches MEMS-Array kann monolithisch aus denselben Substraten aufgebaut sein. In diesem Fall ist der in Figur 1 gezeigte Bereich als Ausschnitt aus einem größeren Bauelement zu verstehen, wobei sich die lateralen Schichten noch weiter nach rechts und links (und natürlich auch senkrecht zur Papierebene) erstrecken und in diesen Raumrichtungen noch weitere ähnlich aufgebaute Schaltelemente umfassen können.

Figur 2 zeigt eine perspektivische Ausschnittsdarstellung eines solchen konventionellen Schaltelements, welches bezüglich seiner Schichtfolge insbesondere ähnlich wie das Schaltelement der Figur 1 aufgebaut sein kann. Die räumliche Orientierung ist jedoch umgekehrt zur Figur 1 gewählt, so dass die Richtung z hier nach unten weist und das Decksubstrat 100 unterhalb des Biegeelements 10 liegt. Im Fußbereich 10a des Biegeelements ist dieses an die übrigen Schichten des SOI-Schichtsystems 50 angebunden und über die flächige Wafer-Verbindung mit dem Decksubstrat 100 verbunden. Im mittleren Bereich 10b ist das Biegeelement relativ breit und tritt elektrostatisch mit der Steuerelektrode 110 auf dem Decksubstrat in Wechselwirkung, insbesondere wenn diese über den skizzierten Steuer-Schaltkreis mit einer Spannung beaufschlagt wird. Im Endbereich 10c ist das Biegeelement ebenfalls relativ breit und trägt einen hier nicht sichtbaren Schaltkontakt. Gegenüberliegend findet sich in diesem Beispiel ein Paar von nebeneinanderliegenden Gegenkontakten 120 auf dem Decksubstrat (also ein Eingangskontakt 121 und ein Ausgangskontakt 122). Bei Auslenkung des Biegeelements werden diese beiden Kontakte 121 und 122 mit dem Schaltkontakt des Biegeelements und durch diesen auch miteinander elektrisch verbunden. Die dargestellten "Taillierungen" - also die verringerte Breite des Biegeelements 10 sowohl zwischen Fußbereich 10a und mittlerem Bereich 10b als auch zwischen mittlerem Bereich 10b und Endbereich 10c dient jeweils dazu, auch bei einer eventuell vorliegenden Torsion des Biegeelements eine Korrektur dieser Verdrehung zu ermöglichen, so dass ein möglichst flächige Kontakt bzw. eine flächige Wechselwirkung der einander gegenüberliegenden Bereiche des Biegeelements 10 und des Decksubstrats 100 zustande kommen kann.

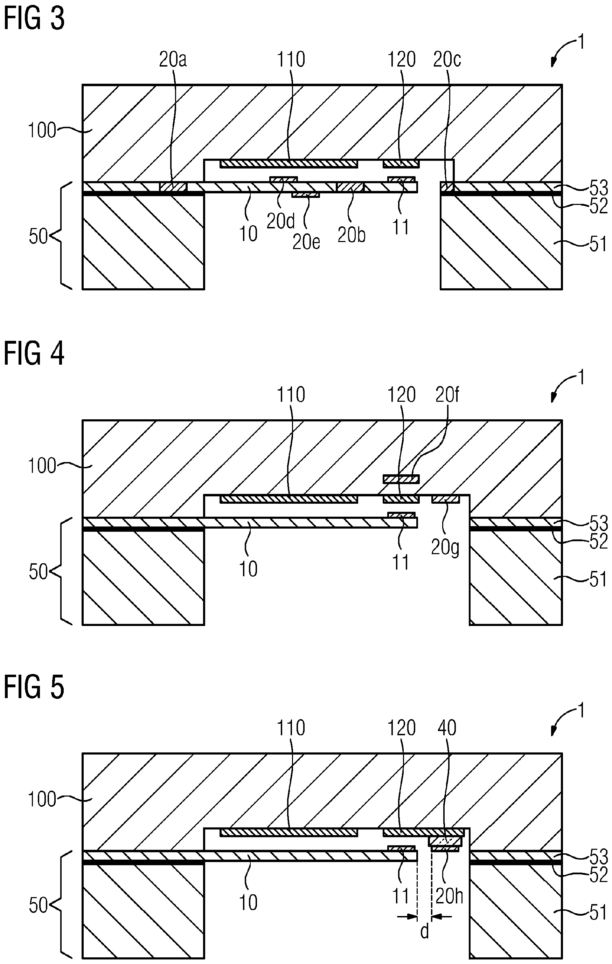

Figur 3 zeigt eine schematische Querschnittsdarstellung eines Schaltelements 1 nach einem ersten Beispiel der Erfindung. Die grundlegende Funktionalität ist analog zu der Funktionalität des herkömmlichen Schaltelements 1 der Figuren 1 und 2, soweit es im Folgenden nicht abweichend beschrieben ist. Allerdings ist diese Funktionalität um ein Sensorelement zur Messung einer Temperatur in der unmittelbaren Umgebung des Biegeelements 10 erweitert. Beim diesem Beispiel ist das Sensorelement im bzw. am Biegeelement 10 angeordnet. Dabei zeigt die Figur 3 mehrere alternative Positionen, an denen ein solches Sensorelement angeordnet sein kann. Dabei wird bei einer tatsächlichen Realisierung eines solchen Schaltelements aber meist nur ein Sensorelement in einer dieser Positionen vorliegen. Das Sensorelement 20a ist ein Sensorelement, das in der Umgebung des Fußbereichs des Biegeelements in dessen funktionelle Schicht 53 integriert ist oder zumindest einen Teil dieser Schicht für die Funktion des Sensorelements nutzt. Alternativ kann ein Sensorelement 20b in den mittleren Bereich des Biegeelements integriert sein, oder es kann ein Sensorelement 20c in einem Bereich gegenüber dem auslenkbaren Endbereich des Biegeelements angeordnet sein. Allen drei Varianten 20a, 20b und 20c ist gemeinsam, dass ein Teil der Halbleiterschicht 53 für die Funktion des Sensorelements genutzt wird. Die möglich Funktionsweisen werden dabei noch im Zusammenhang mit weiteren Beispielen erläutert.

Alternativ zu den gezeigten Sensorelementen in der Schicht 53 kann aber auch ein Sensorelement 20d bzw. 20e als zusätzliches Element auf das Biegeelement aufgebracht sein. So ist das Sensorelement 20d auf einer dem Decksubstrat zugewandten Oberseite auf das Biegeelement aufgebracht, und das alternative Sensorelement 20e ist auf der gegenüberliegenden Unterseite auf das Biegeelement aufgebracht. Hier wird die Funktionalität des Sensorelements durch zusätzliche funktionale Schichten bereitgestellt, welche auf die Halbleiterschicht 53 aufgebracht sind. Prinzipiell kann aber auch eine Kombination der beiden Ausführungsvarianten vorliegen, bei der das Sensorelement zum einen die Halbleiterschicht 53 nutzt und außerdem noch ein oder mehrere zusätzlich aufgebrachte Schichten umfasst.

Figur 4 zeigt eine schematische Querschnittsdarstellung eines Schaltelements 1 nach einem weiteren Beispiel der Erfindung. Auch hier ist die grundlegende Funktionalität analog zum herkömmlichen Schaltelement 1 der Figuren 1 und 2. Ähnlich wie beim Beispiel der Figur 3 ist auch hier ein Sensorelement zur Temperaturmessung in das Schaltelement integriert, allerdings bei dieser Ausführungsvariante im Bereich des Decksubstrats 10. Hierfür zeigt Figur 4 wiederum zwei alternative mögliche Positionen, nämlich ein Sensorelement 20f, welches oberhalb eines Gegenkontakts 120 in das Substrat eingebettet ist und ein anderes Sensorelement 20g, welches in lateraler Richtung neben dem Gegenkontakt 120 angeordnet ist und auf einer Außenfläche des Decksubstrats 100 liegt. Bei diesen beiden Beispielen wird eine galvanische Trennung der Sensorelemente 20f und 20g von dem Gegenkontakt des Laststromkreises entweder durch die laterale oder durch die vertikale Beabstandung in Verbindung mit den isolierenden Eigenschaften des Decksubstrats bzw. einer hier nicht näher dargestellten Zwischenschicht erreicht. In Figur 5 ist noch eine weitere Alternative für die Integration auf dem Decksubstrat gezeigt, nämlich ein Sensorelement 20h, welches auf einem Gegenkontakt 120 angeordnet ist, aber durch eine dazwischenliegende Isolationsschicht 40 galvanisch von diesem getrennt ist. Für das Beispiel der Figur 5 ist auch ein lateraler Abstand d angegeben, um den das Sensorelement 20h von dem Biegeelement 10 beabstandet ist. Sowohl hier als auch bei den anderen gezeigten Beispielen ist dieser laterale Abstand d wesentlich kleiner als die Ausdehnung des Biegeelements 10 in dieser lateralen Richtung.

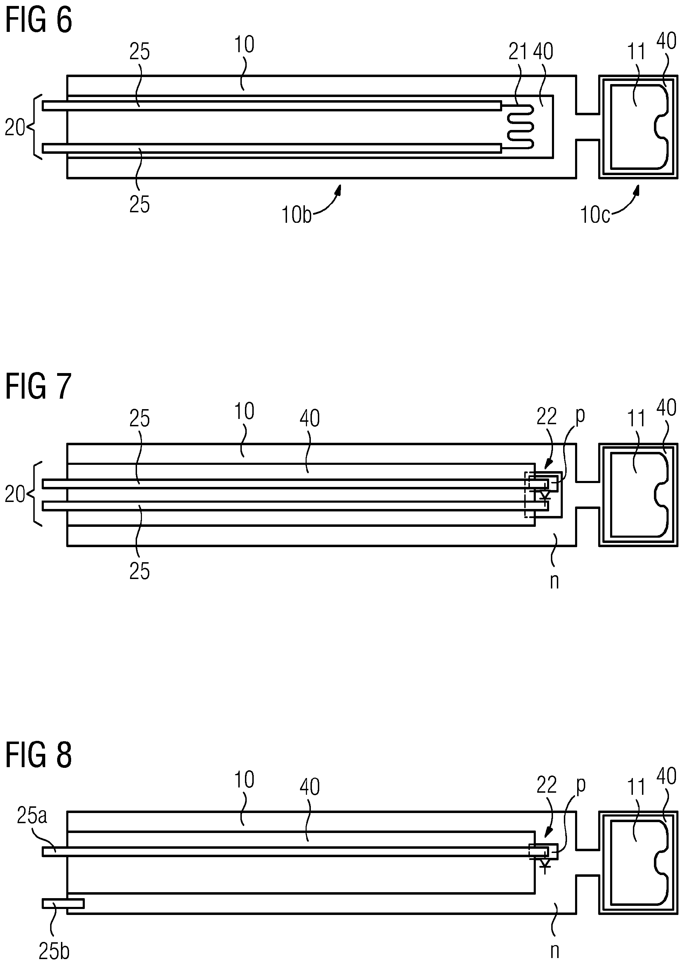

Das Sensorelement, das gemäß den Figuren 3 bis 5 an unterschiedlichen Positionen angeordnet sein kann, kann auch prinzipiell auf unterschiedliche Weise aufgebaut sein und auf verschiedenen möglichen Messprinzipien basieren. Beispielhaft hierfür sind einige unterschiedliche Messprinzipien in den Figuren 6 bis 15 dargestellt. Dabei zeigen Figuren 6 bis 9 verschiedene Ausgestaltungen von Sensorelementen, die im oder am Biegeelement angeordnet sind in schematischer Aufsicht auf die Schichtebene des mehrschichtigen Trägersubstrats. Beim Beispiel der Figur 6 wird das Sensorelement 20 durch ein zusätzliches funktionales Schichtsystem gebildet, welches auf der Halbleiterschicht 53 des Biegeelements 10 aufgebracht ist. Dabei ist zunächst eine Isolationsschicht 40 aufgebracht, und zwar sowohl im mittleren Bereich 10b des Biegeelements als auch im Endbereich 10c, der den Schaltkontakt 11 trägt. Im mittleren Bereich 10b ist auf dieser Isolationsschicht 40 eine mäanderförmige Widerstandsstruktur 21 aufgebracht, insbesondere aus einem metallischen Material mit positivem Temperaturkoeffizienten. Um eine Messung der Temperatur mit einem übergeordneten Messstromkreis zu ermöglichen, ist diese Widerstandsstruktur 21 über zwei Zuleitungen 25 mit dem Messstromkreis verbunden. Durch die Isolationsschicht 40 ist der Messstromkreis von dem Steuerstromkreis, in den auch das Halbleitermaterial des Biegeelements eingebunden ist, galvanisch getrennt.

Beim Beispiel der Figur 7 nutzt das Sensorelement einen Teilbereich der halbleitenden Schicht des Biegeelements für die Funktionalität der Temperaturmessung. In diesem Teilbereich ist ein p-n-Übergang 22 ausgebildet, wobei die n-dotierte Zone mit n und die p-dotierte Zone mit p bezeichnet ist. Somit ist hier eine Diode ausgebildet, deren temperaturabhängige Eigenschaften mit dem Messstromkreis gemessen werden können. Hierzu ist diese Diode wiederum mit zwei Zuleitungen 25 an den Messstromkreis angebunden, wobei die Zuleitungen 25 durch eine isolierende Schicht von dem Halbleitermaterial des Biegeelements getrennt sind. Über den p-n-Übergang 22 selbst ist aber bei diesem Beispiel der Messstromkreis mit dem Steuerstromkreis gekoppelt.

Auch beim Beispiel der Figur 8 nutzt das Sensorelement einen kleinen Teilbereich der halbleitenden Schicht des Biegeelements für die Funktionalität der Temperaturmessung. In diesem Beispiel bildet der Großteil des Halbleitermaterials des Biegeelements eine n-dotierte Zone n aus, und nur ein kleiner Teilbereich bildet eine p-dotierte Zone. Auch hierdurch ist ein p-n-Übergang mit temperaturabhängigen elektrischen Eigenschaften gegeben. Die Anbindung an den Messstromkreis erfolgt über zwei Zuleitungen, wobei die erste Zuleitung 25a durch eine Isolationsschicht 40 von dem Halbleitermaterial getrennt ist und die zweite Zuleitung 25b direkt an das Halbleitermaterial des Biegeelements angeschlossen ist.

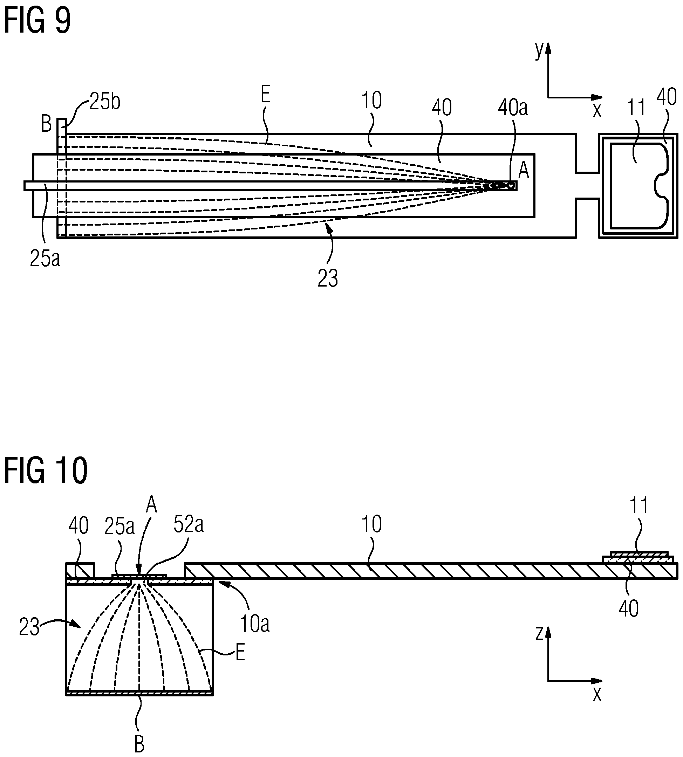

Beim Beispiel der Figur 9 nutzt das Sensorelement einen großen Bereich der halbleitenden Schicht des Biegeelements für die Temperaturmessung. Hierzu ist zwischen einer ersten Elektrode A und einer zweiten Elektrode B ein Ausbreitungswiderstands-Sensor 23 im Halbleitermaterial des Biegeelements ausgebildet, der sich über einen überwiegenden Teil der Länge des Biegeelements erstreckt. Die erste Elektrode A ist dabei durch ein Pinhole 40a in einer auf den Halbleiter aufgebrachten Isolationsschicht 40 gegeben. Die zweite Elektrode B ist ein in y-Richtung deutlich ausgedehnter Kontakt. Beispielhaft sind einige Feldlinien E gezeigt, die zeigen, wie sich ein elektrisches Feld über den relativ großen Bereich zwischen dem Pinhole-Kontakt A und dem größeren Kontakt B im Halbleitermaterial ausbreitet.

Auch beim Beispiel der Figur 10 ist als Sensorelement ein Ausbreitungswiderstands-Sensor 23 vorgesehen, bei welchem ein Halbleitermaterial als Sensorschicht genutzt wird. Figur 10 zeigt dieses Beispiel im schematischen Querschnitt. Im Unterschied zum vorgehenden Beispiel wird hier das Material der dickeren, ersten Siliziumschicht 51 genutzt, also die Trägerschicht. Das Sensorelement ist hier also nicht in das Biegeelement selbst integriert, sondern in den Teil des Trägersubstrats, der im Fußbereich 10a an das Biegeelement angrenzt. Auch hier ist der Ausbreitungswiderstands-Sensor 23 zwischen einer sehr kleinräumigen ersten Elektrode A und einer größerflächigen zweiten Elektrode B ausgebildet. Die erste Elektrode A ist dabei durch die Metallisierung einer ersten Zuleitung 25a in Verbindung mit einem Pinhole 52a in der Oxidschicht 52 des SOI-Schichtsystems definiert. Die zweite Elektrode B ist durch eine größerflächige Metallisierung auf der Unterseite des SOI-Substrats gebildet und über eine entsprechende hier nicht dargestellte Zuleitung mit dem Messstromkreis verbunden.

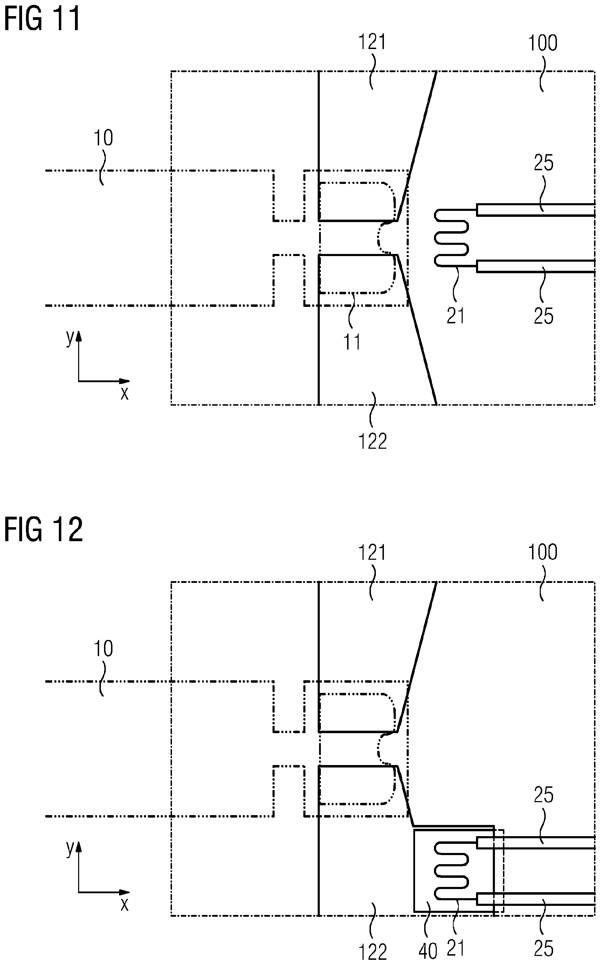

In den Figuren 11 bis 14 sind schließlich mehrere Beispiele dafür gezeigt, wie das Sensorelement im Bereich des Decksubstrats in das Schaltelement integriert sein kann. So zeigt Figur 11 einen Ausschnitt des Decksubstrats 100 im Endbereich des Biegeelements. Das in einer anderen Ebene liegende Biegeelement 10 ist hier durch gestrichelte Linien angedeutet. Das Decksubstrat weist gegenüber dem Endbereich des Biegeelements zwei Gegenkontakte 121 und 122 auf, welche im ausgelenkten Zustand des Biegeelements durch den dort angebrachten Schaltkontakt miteinander kontaktiert werden. Das Sensorelement ist hier durch eine Widerstandsstruktur 21 gegeben, welche in lateraler Richtung (hier in x-Richtung) von den Gegenkontakten 121 und 122 beabstandet angeordnet ist. Die Widerstandsstruktur ist über zwei Zuleitungen 25 mit einem Messstromkreis verbunden, wobei der Messstromkreis aufgrund der elektrisch isolierenden Eigenschaften des Decksubstrats galvanisch von dem Laststromkreis der Kontakte 121 und 122 getrennt ist.

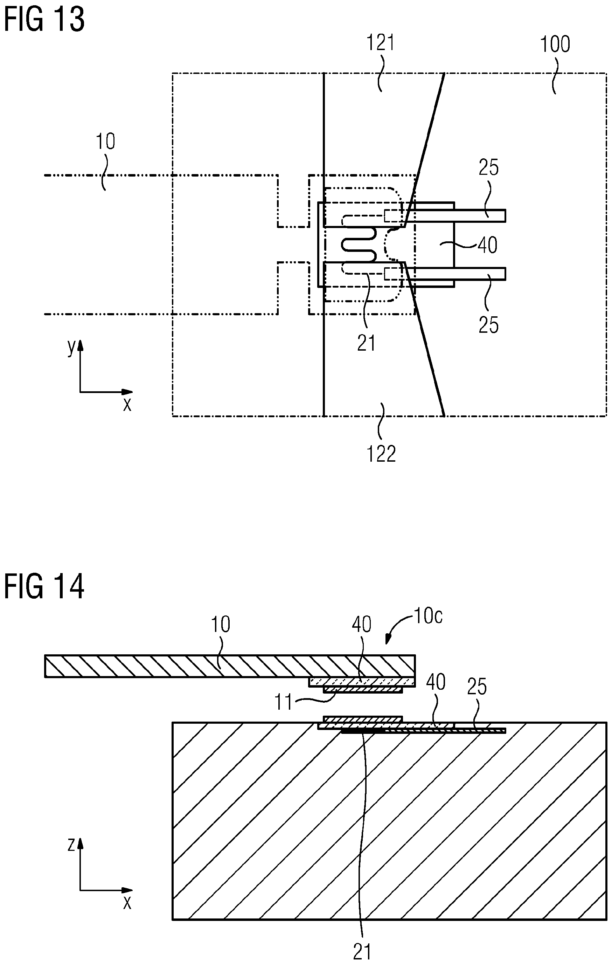

Auch beim Beispiel der Figur 12 ist ein Sensorelement in Form einer Widerstandsstruktur 21 auf das Decksubstrat 100 aufgebracht. Im Unterschied zum vorhergehenden Beispiel überlappt diese Widerstandsstruktur 21 mit dem zweiten Gegenkontakt 122. Allerdings ist es von diesem durch eine Isolationsschicht 40 galvanisch getrennt. In ähnlicher Weise ist beim Beispiel der Figur 13 ein Sensorelement durch eine Widerstandsstruktur 21 gebildet, welche hier sogar mit beiden Gegenkontakten 121 und 122 überlappt, aber wiederum durch eine Isolationsschicht 40 von ihnen galvanisch getrennt ist. Das Ausführungsbeispiel der Figur 13 ist zusätzlich in Figur 14 im schematischen Querschnitt gezeigt.

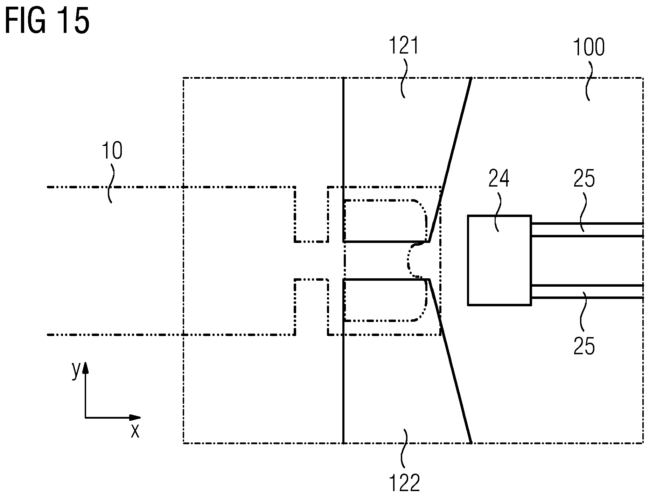

Figur 15 zeigt ein weiteres Ausführungsbeispiel der Erfindung in schematischer Aufsicht auf die Ebene des Decksubstrats 100. Ähnlich wie beim Beispiel der Figur 11 ist hier das Sensorelement lateral von den beiden Gegenkontakten 121 und 122 beabstandet und durch das isolierende Decksubstrat von dem Laststromkreis getrennt. Im Unterschied zu den vorhergehenden Beispielen ist hier aber das Sensorelement nicht zusammen mit den übrigen Teilen des Schaltelements in einem gemeinsamen Herstellungsverfahren gefertigt und monolithisch integriert, sondern bildet ein vorgefertigtes Sensor-Bauteil 24, welches erst nach seiner Fertigung an dieser Stelle positioniert und eingebaut und mit entsprechenden Zuleitungen 25 verbunden wurde. Bei dem vorgefertigten Sensor-Bauteil 24 kann es sich beispielsweise um ein Thermoelement handeln.

### Bezugszeichenliste

- 1: MEMS-Schaltelement
- 10: Biegeelement
- 10a: Fußbereich
- 10b: mittlerer Bereich
- 10c: Endbereich
- 11: Schaltkontakt
- 20: Sensorelement
- 20a: Sensorelement im Fußbereich des Biegeelements
- 20b: Sensorelement im mittleren Bereich des Biegeelements
- 20c: Sensorelement gegenüber dem Biegeelement
- 20d: Sensorelement am Biegeelement (Oberseite)
- 20e: Sensorelement am Biegeelement (Unterseite)
- 20f: Sensorelement im Decksubstrat
- 20g: Sensorelement auf dem Decksubstrat
- 20h: Sensorelement auf dem Decksubstrat
- 21: Widerstandsstruktur
- 22: p-n-Übergang
- 23: Ausbreitungswiderstands-Sensor
- 24: vorgefertigtes Sensor-Bauteil (Thermoelement)
- 25: Zuleitung des Sensorelements
- 25a: erste Zuleitung
- 25b: zweite Zuleitung
- 40: Isolationsschicht
- 40a: Pinhole in Isolationsschicht
- 50: mehrschichtiges Trägersubstrat (SOI-Schichtsystem)
- 51: erste Siliziumschicht
- 52: Oxidschicht
- 52a: Pinhole in der Oxidschicht
- 53: zweite Siliziumschicht
- 100: Decksubstrat
- 105: Ausnehmung des Decksubstrats
- 110: Steuerelektrode
- 120: Gegenkontakte (Paar von Lastkontakten)
- 121: erster Gegenkontakt (Eingangskontakt)
- 122: zweiter Gegenkontakt (Ausgangskontakt)
- A,B: Elektroden des Sensorelements
- d: Abstand
- E: elektrische Feldlinien
- n: n-dotierte Zone
- p: p-dotierte Zone
- x,y: laterale Richtungen
- z: vertikale Richtung

## Patentansprüche

1. Mikroelektromechanisches Schaltelement (1), umfassend
- ein mehrschichtiges Trägersubstrat (50) mit einer funktionellen Schicht (53), in der ein auslenkbares Biegeelement (10) ausgebildet ist,
- sowie ein Sensorelement (20,20a-20h), welches zur Messung einer Temperatur ausgelegt ist und in der unmittelbaren Umgebung des Biegeelements (10) angeordnet ist und diesem zugeordnet ist.

2. Schaltelement (1) nach Anspruch 1, bei welchem der Abstand (d) zwischen Sensorelement (20) und Biegeelement (10) in lateraler Richtung (x,y) höchstens so groß ist wie die Ausdehnung des Biegeelements (10) in dieser Richtung.

3. Schaltelement (1) nach einem der Ansprüche 1 oder 2, welches eine Steuerelektrode (110) aufweist, mit welcher die Auslenkung des Biegeelements (10) beeinflusst werden kann, wobei die Steuerelektrode (110) Teil eines Steuerstromkreises ist.

4. Schaltelement (1) nach Anspruch 3,
- wobei das Biegeelement (10) dazu ausgebildet ist, einen Laststromkreis zu öffnen und zu schließen,
- wobei das Sensorelement (20) Teil eines Messstromkreises ist,
- und wobei der Messtromkreis von dem Laststromkreis und/oder dem Steuerstromkreis galvanisch getrennt ist.

5. Schaltelement (1) nach einem der vorhergehenden Ansprüche,
- welches ein Decksubstrat (100) aufweist
- und bei welchem an dem Biegeelement (10) ein Schaltkontakt (11) angeordnet ist,
- wobei das Decksubstrat (100) wenigstens einen Gegenkontakt (120) trägt, welcher abhängig von einer Auslenkung des Biegeelements (10) mit dem Schaltkontakt (11) des Biegeelements (10) kontaktierbar ist.

6. Schaltelement (1) nach einem der vorhergehenden Ansprüche, bei welchem das mehrschichtige Trägersubstrat (50) ein Silicon-on-Insulator-Schichtsystem ist.

7. Schaltelement (1) nach einem der vorhergehenden Ansprüche, bei welchem das Sensorelement (20) in die funktionelle Schicht (53) des Biegeelements (10) integriert ist und/oder auf das Biegeelement (10) aufgebracht ist.

8. Schaltelement (1) nach einem der Ansprüche 1 bis 6,
- welches ein Decksubstrat (100) aufweist,
- wobei das Sensorelement (20) in das Decksubstrat (100) integriert ist und/oder auf dem Decksubstrat (100) aufgebracht ist.

9. Schaltelement (1) nach einem der vorhergehenden Ansprüche, bei welchem das Sensorelement (20) einen in Dünnschichttechnologie aufgebrachter Kaltleiter (21) aufweist.

10. Schaltelement (1) nach einem der Ansprüche 1 bis 8, bei welchem das Sensorelement (20) einen p-n-Übergang (22) innerhalb einer Halbleiterschicht (53) aufweist und/oder auf der Messung einer Widerstandsänderung in einer Halbleiterschicht (53,51) basiert.

11. Schaltelement (1) nach einem der Ansprüche 1 bis 8, bei welchem das Sensorelement als Thermoelement (24) ausgebildet ist.

12. Schaltelement (1) nach einem der Ansprüche 1 bis 8, bei welchem das Sensorelement durch ein vorgefertigtes Sensor-Bauteil (24) gebildet ist, welches in das Schaltelement (1) eingebaut ist.

13. Vorrichtung mit einem mikroelektromechanischen Schaltelement (1) oder einem Array von mehreren mikroelektromechanischen Schaltelementen (1) nach einem der vorhergehenden Ansprüche.

14. Verfahren zum Betreiben eines Schaltelements (1) nach einem der Ansprüche 1 bis 12 oder einer Vorrichtung nach Anspruch 13, umfassend die folgenden Schritte:
a) Umschalten zwischen einem ON-Zustand und einem OFF-Zustand eines übergeordneten Laststromkreises durch eine Auslenkung des Biegeelements (10),
b) Messen einer Temperatur in der unmittelbaren Umgebung des Biegeelements (10) mit dem Sensorelement (20).

15. Verfahren nach Anspruch 14 mit den folgenden zusätzlichen Schritten:
c) Vergleichen des Messsignals des Sensorelements (20) mit einem vorgegebenen Schwellwert und
d) Deaktivierung des Schaltelements (1) bei Über- oder Unterschreiten des Schwellwerts
sowie optional den weiteren Schritt
e) Überwachung eines Zustands des Schaltelements und/oder der Vorrichtung durch Vergleich von gemessenen Temperaturkurven.
